# EUROPEAN PATENT APPLICATION

(11) **EP 0 930 377 A1**
(43) Date of publication of application: **21.07.1999**
(21) Application number: 99300325.0
(22) Date of filing: 19.01.1999
(51) Int. Cl.: C23C 16/02

(54) **Bonding diamond to substrate**

(30) Priority: 20.01.1998 GB 9801166
(71) Applicant: DE BEERS INDUSTRIAL DIAMOND DIVISION (PROPRIETARY) LIMITED, Johannesburg (ZA)
(72) Inventor: Collins, John Lloyd, Willesden Green, London NW12 1RG (GB)
(74) Representative: Jones, Alan John

(57) **Abstract**

A CVD diamond layer is bonded to a surface of a tungsten carbide substrate by forming a layer of tungsten silicide on a surface of the substrate and thereafter depositing a layer of CVD diamond on the tungsten silicide layer.

## Description

### BACKGROUND OF THE INVENTION

This invention relates to the bonding of diamond, more particularly, diamond produced by chemical vapour deposition, to a substrate.

Methods of depositing material such as diamond on a substrate by chemical vapour deposition ("CVD") are now well established and have been described extensively in the patent and other literature. Where diamond is being deposited on a substrate, the method generally involves providing a gas mixture which, on dissociation, can provide hydrogen or a halogen (e.g. F,Cl) in atomic form and C or carbon containing radicals and other reactive species, e.g. CHₓ, CFₓ wherein x can be 1 to 4. In addition, oxygen containing sources may be present, as may sources for nitrogen, and for boron. In many processes, inert gases such as helium, neon or argon are also present. Thus, a typical source gas mixture will contain hydrocarbons CₓH_{y}, wherein x and y can each be 1 to 10, halocarbons CₓY_{y}Hal_{z} wherein x, y and z can each be 1 to 10, optionally one or more of the following: CO,CO₂, O₂, H₂, N₂, NH₃, B₂H₆, and an inert gas. Each gas may be present in its natural isotopic ratio, or the relative isotopic ratios may be artificially controlled; for example hydrogen may be present as deuterium or tritium, and carbon may be present as ¹²C or ¹³C. Dissociation of the source gas mixture is brought about by an energy source such as microwaves, lasers, RF energy, a flame, or a hot filament, and the reactive gas species so produced are allowed to deposit onto a substrate and form diamond.

Diamond which is produced by CVD may be single crystal or polycrystalline in nature. Such diamond will hereinafter be referred to as "CVDD".

The adhesion of CVDD to cobalt-containing tungsten carbide (WC) is known to be severely affected by the chemical solubility of the CVDD in the cobalt which forms a part of the sintered WC matrix. In particular, even if the WC-Co surface is chemically leached of Co to a depth of several tens of microns, over the deposition time for the minimum usable thickness (perhaps 10µm) at typical CVDD deposition temperatures (of between 700° - 1200° C) the diffusivity of the Co is such that it reaches the CVDD-WC interface and weakens (even destroys) the interfacial chemical bond. The interface strength can be increased by a chemical or physical decarburisation process but this increase is often insufficient and does not give the layer suitable adhesion for the majority of mechanical applications. The mechanical bond between the CVDD and the WC substrate is insufficient, even if enhanced by various surface profiling or keying techniques.

Such poor and inconsistent adhesion of CVDD to such treated WC-Co matrices limits the use of CVDD-WC composite components, precluding their use in eminently suitable applications. Such applications might be bearing and seal components, coated cutting tool inserts and other parts of tools/knives where the adhesion of CVDD to the WC-Co gives enhanced wear and abrasion resistance and prolonged lifetime.

Various attempts have been made to deposit by physical or chemical means an interlayer of a metal or compound to which CVDD is known to adhere when it is in the bulk form. However, these have been shown to have inconsistent adhesion and poor adhesion strengths since the interlayer has poor adhesion to the WC-Co itself.

### SUMMARY OF THE INVENTION

According to the present invention, a method of bonding a CVDD layer to a surface of a tungsten carbide substrate includes the steps of forming a layer of tungsten silicide on a surface of the substrate and thereafter depositing a layer of CVDD on the tungsten silicide layer.

Further according to the invention, the layer of tungsten silicide is produced by depositing a layer of silicon on a surface of the substrate and causing the silicon to form tungsten silicide. The layer of silicon may be produced by chemical decomposition, the tungsten silicide forming as the silicon from the decomposition reaction diffuses into the substrate. The silicon layer, and the tungsten silicide layer formed, will generally be continuous, although the layer may also include discontinuities or breaks in it. The layer will typically be thin, e.g. less than 5µm in thickness.

It is preferred that the surface on which the layer of tungsten silicide is formed is a decarburised surface. The decarburised surface may be produced by leaching the surface and thereafter decarburising the surface by means of a chemical process, e.g. treating the surface with Murakami's etchant, or by a physical process, e.g. plasma or high temperature decarburisation of the surface in an oxygen/hydrogen/argon gas stream.

The layer of CVDD can be deposited on the tungsten silicide layer by any method known in the art.

The tungsten carbide, also known as cemented tungsten carbide, for the substrate will comprise a mass of tungsten carbide particles bonded into a coherent form by means of a bonding matrix such as nickel, iron or cobalt or alloy containing one or more of these metals. The bonding matrix is preferably cobalt.

Further according to the invention, there is provided a body comprising a CVD diamond layer bonded to a tungsten carbide substrate through a layer of tungsten silicide. The layer of tungsten silicide will typically be thin, e.g. less than 5µm in thickness.

### DESCRIPTION OF AN EMBODIMENT

An embodiment of the invention will now be described. A tungsten carbide/cobalt substrate was provided. A surface of the substrate was chemically leached to remove cobalt to a depth of about 1µm. Thereafter, that surface was decarburised of the remaining tungsten carbide to a depth of about 1µm either by chemical means, e.g. treating the surface with Murakami's etchant or by physical means, e.g. plasma or high temperature decarburisation of the surface in an oxygen/hydrogen/argon gas stream.

The thus treated substrate was placed in a suitable reactor and a layer of silicon (about 1 - 2µm) deposited on the decarburised surface by decomposing silicon hydride in a hydrogen/argon atmosphere. The decarburised surface was heated to a temperature of about 400°C. Tungsten remained on the decarburised surface which reacted with the silicon from the decomposition reaction as it diffused into the substrate. An integral layer of tungsten silicide was produced which bonded rapidly and strongly to the decarburised surface. A layer of CVDD was then deposited on the tungsten silicide layer using methods known in the art. It was found that the CVDD was highly adherent to the tungsten silicide and no degradation of the CVDD-tungsten silicide layer due to cobalt binder phase migrating into the layer was observed. The tungsten silicide appeared to act as a barrier layer to the diffusion of cobalt from the bulk of the substrate and thus the CVDD-tungsten silicide interface remained intact even after extended deposition of CVDD at elevated temperature.

The method of the invention enables high toughness tungsten carbide/cobalt to be produced with highly abrasion and erosion resistant coatings, thus opening the field to CVDD coated seals and bearings using suitably hard and tough substrate materials which can be conventionally machined or, by using electrically conducting CVDD, EDM machined to the finished component.

## Claims

1. A method of bonding a CVD diamond layer to a surface of a tungsten carbide substrate includes the steps of forming a layer of tungsten silicide on a surface of the substrate and thereafter depositing a layer of CVD diamond on the tungsten silicide layer.

2. A method according to claim 1 wherein the layer of tungsten silicide is produced by depositing a layer of silicon on a surface of the substrate and causing the silicon to form tungsten silicide.

3. A method according to claim 2 wherein the layer of silicon is produced by chemical decomposition, the tungsten silicide forming as silicon from the decomposition reaction diffuses into the substrate.

4. A method according to claim 2 or claim 3 wherein the silicon layer is continuous.

5. A method according to any one of claims 2 to 4 wherein the silicon layer is less than 5µm in thickness.

6. A method according to any one of the preceding claims wherein the surface on which the layer of tungsten silicide is formed is a decarburised surface.

7. A method according to claim 6 wherein the decarburised surface is produced by leaching the surface and thereafter decarburising the surface.

8. A method according to claim 7 wherein decarburisation is achieved by means of a chemical process.

9. A method according to claim 8 wherein the chemical process includes treating the surface with Murakami's etchant.

10. A method according to claim 7 wherein the decarburisation is achieved by means of a physical process.

11. A method according to claim 10 wherein the physical process is plasma or high temperature decarburisation of the surface in a hydrogen/argon gas stream.

12. A method according to any one of the preceding claims wherein the bonding matrix for the tungsten carbide is cobalt.

13. A body comprising a CVD diamond layer bonded to a tungsten carbide substrate through a layer of tungsten silicide.

14. A body according to claim 13 wherein the layer of tungsten silicide is less than 5µm in thickness.

15. A body according to claim 13 or claim 14 wherein the layer of tungsten silicide is a continuous layer.
